# DEMANDE DE BREVET EUROPEEN

(11) **EP 3 748 437 A1**
(43) Date de publication de la demande: **09.12.2020**
(21) Numéro de dépôt: 19178963.5
(22) Date de dépôt: 07.06.2019
(51) Int. Cl.: G04B 13/02

(54) **FABRICATION D'UN COMPOSANT HORLOGER**

(71) Demandeur: ROLEX SA, 1211 Genève 26 (CH)
(72) Inventeur: CALAME, Florian, CH 1066 EPALINGES (CH); MULTONE, Xavier, CH 1005 Lausanne (CH)
(74) Mandataire: Moinas & Savoye SARL

(57) **Abrégé**

Procédé de fabrication par photolithographie d'un moule (10 ; 10') multicouche en résine comprenant une cavité (11 ; 11') dotée d'une entrée (110 ; 110') pour la fabrication d'un composant horloger, caractérisé en ce qu'il comprend les sous-étapes suivantes pour fabriquer au moins deux couches (C10, C20 ; C20', C30') en résine du moule (10 ; 10') :
o Des sous-étapes (E11, E12, E13 ; E105', E106', E107') de fabrication d'une première couche (C10 ; C20') en résine, comprenant une première ouverture (111 ; 111') traversante ou débouchante orientée vers la direction de l'entrée (110 ; 110') du moule, pour délimiter un premier volume de la cavité (11 ; 11') du moule (10 ; 10') ;
o Des sous-étapes (E14, E15, E16 ; E108', E109', E110') de fabrication d'une deuxième couche (C20 ; C30') en résine comprenant un film rigide, ladite deuxième couche comprenant une deuxième ouverture (112 ; 112') traversante délimitant un deuxième volume de la cavité (11 ; 11') du moule (10 ; 10'), la deuxième ouverture (112 ; 112') traversante de cette deuxième couche étant au moins partiellement superposée à la première ouverture (111 ; 111') traversante ou débouchante de la première couche et la deuxième couche en résine recouvrant partiellement cette même première ouverture (111 ; 111') traversante ou débouchante de la première couche en résine.

## Description

La présente invention concerne un procédé de fabrication d'un composant horloger. Elle concerne aussi un procédé de fabrication d'un moule destiné à être utilisé dans ledit procédé de fabrication d'un composant horloger. Elle porte aussi sur un moule en tant que tel.

DGC Mitteilungen No. 104, 2005, mentionne l'utilisation de la technologie LIGA (Lithographie Galvanik Abformung : méthode conçue par W. Ehrfeld du Karlsruhe Nuclear Research Center, Allemagne) pour la fabrication de pièces métalliques horlogères de haute précision, telles que, par exemple, des ancres ou des roues d'échappement. Ce procédé comprend la formation d'un moule en résine sensible aux rayons X, par irradiation avec un faisceau de rayons X de haute énergie spécifiquement généré par un synchrotron, ce qui peut représenter un inconvénient en matière d'équipement.

A.B. Frazier et al., Journal of Microelectromechanical systems, 2, 2, June 1993, décrit la fabrication de structures métalliques par électrodéposition de métal dans des moules en résine photosensible (photorésist) à base de polyimide, préparés à l'aide d'un procédé utilisant une technologie appelée LIGA-UV, analogue à la technologie LIGA mentionnée ci-dessus mais avec une illumination UV de la résine à la place de l'irradiation aux rayons X.

Les demandes de brevet EP2004881 et EP2405301 décrivent, par exemple, des solutions utilisant une telle technologie pour fabriquer des composants horlogers métalliques complexes, en particulier des composants horlogers multiniveaux.

Ces solutions existantes permettent la fabrication de composants horlogers avec une bonne définition. Toutefois, ces procédés existants nécessitent souvent des étapes de finition plus ou moins fastidieuses, qui complexifient le procédé de fabrication, particulièrement lorsque la géométrie du composant est élaborée. Ainsi, la présente invention a pour objet de proposer une solution améliorée de fabrication d'un composant horloger.

Plus particulièrement, un objet de l'invention est de pouvoir fabriquer un composant horloger de géométrie complexe, comme un pignon arbré, permettant d'atteindre une définition suffisante, notamment un état de surface suffisant, sur l'ensemble de ses surfaces fonctionnelles, en particulier sur les surfaces fonctionnelles du pignon, pour lui permettre de remplir sa fonction de manière efficace. Par « surface fonctionnelle du pignon », nous entendons notamment une surface prenant part à la fonction d'engrènement du pignon. Il peut s'agir d'une surface d'une dent, par exemple une surface inférieure ou supérieure d'une dent. Par « pignon », nous entendons tout composant denté présentant une fonction d'engrènement.

A cet effet, l'invention concerne un procédé de fabrication par photolithographie d'un moule multicouche en résine comprenant une cavité dotée d'une entrée pour la fabrication d'un composant horloger, caractérisé en ce qu'il comprend les sous-étapes suivantes pour fabriquer au moins deux couches en résine du moule :
- Des sous-étapes de fabrication d'une première couche en résine, comprenant une première ouverture traversante ou débouchante orientée vers la direction de l'entrée de la cavité du moule, pour délimiter un premier volume de la cavité du moule ;
- Des sous-étapes de fabrication d'une deuxième couche en résine comprenant un film rigide, ladite deuxième couche comprenant une deuxième ouverture traversante délimitant un deuxième volume de la cavité du moule, la deuxième ouverture traversante de cette deuxième couche étant au moins partiellement superposée à la première ouverture traversante ou débouchante de la première couche et la deuxième couche en résine recouvrant partiellement cette même première ouverture traversante ou débouchante de la première couche en résine.

L'invention porte aussi sur un procédé de fabrication d'un composant horloger, caractérisé en ce qu'il comprend une première étape de fabrication d'un moule selon le procédé de fabrication décrit ci-dessus, et une deuxième étape de remplissage au moins partiel de la cavité du moule fabriqué à l'étape précédente, notamment de remplissage des premier et deuxième volumes de ladite cavité dudit moule, afin de fabriquer tout ou partie du composant horloger.

L'invention porte aussi sur un moule multicouche en résine comprenant une cavité dotée d'une entrée, obtenu par photolithographie, pour la fabrication d'un composant horloger, caractérisé en ce qu'il comprend :
- Une première couche en résine, comprenant une première ouverture traversante ou débouchante orientée vers la direction de l'entrée de la cavité du moule, délimitant un premier volume de la cavité du moule ;
- Une deuxième couche en résine comprenant un film rigide, ladite deuxième couche comprenant une deuxième ouverture traversante délimitant un deuxième volume de la cavité du moule, la deuxième ouverture traversante de cette deuxième couche étant au moins partiellement superposée à la première ouverture traversante ou débouchante de la première couche et la deuxième couche en résine recouvrant partiellement cette même première ouverture traversante ou débouchante de la première couche en résine.

L'invention est plus particulièrement définie par les revendications.

Ces objets, caractéristiques et avantages de la présente invention seront exposés en détail dans la description suivante de modes de réalisation particuliers faits à titre non-limitatif en relation avec les figures jointes parmi lesquelles :
Les figures 1 à 7 représentent schématiquement différentes étapes d'un procédé de fabrication d'un moule multicouche en résine par photolithographie pour la fabrication d'un composant horloger selon un premier mode de réalisation de l'invention.
Les figures 8 et 9 illustrent un procédé de fabrication d'un composant horloger à partir du moule fabriqué selon les figures 1 à 7 selon un premier mode de réalisation de l'invention.
La figure 10 représente plus précisément à titre d'exemple un composant horloger obtenu par le procédé de fabrication selon le premier mode de réalisation de l'invention.
Les figures 11 à 17 représentent schématiquement différentes étapes d'un procédé de fabrication d'un moule multicouche en résine par photolithographie pour la fabrication d'un composant horloger selon un deuxième mode de réalisation de l'invention.
Les figures 18 à 20 illustrent un procédé de fabrication d'un composant horloger à partir du moule fabriqué selon les figures 11 à 17 selon un deuxième mode de réalisation de l'invention.
La figure 21 représente une vue de dessus de détails du moule de fabrication selon une variante du deuxième mode de réalisation de l'invention.
La figure 22 représente plus précisément à titre d'exemple un composant horloger obtenu par le procédé de fabrication selon le deuxième mode de réalisation de l'invention.
La figure 23 représente à titre d'exemple la coupe d'un composant horloger obtenu par le procédé de fabrication selon une variante du deuxième mode de réalisation de l'invention.

L'invention repose en premier lieu sur une première étape qui consiste en un procédé de fabrication d'un moule multicouche particulièrement avantageux, qui permettra ensuite de fabriquer un composant horloger dans une deuxième étape.

Les différentes sous-étapes d'une première étape E1 de fabrication d'un moule selon un mode de réalisation vont maintenant être décrites.

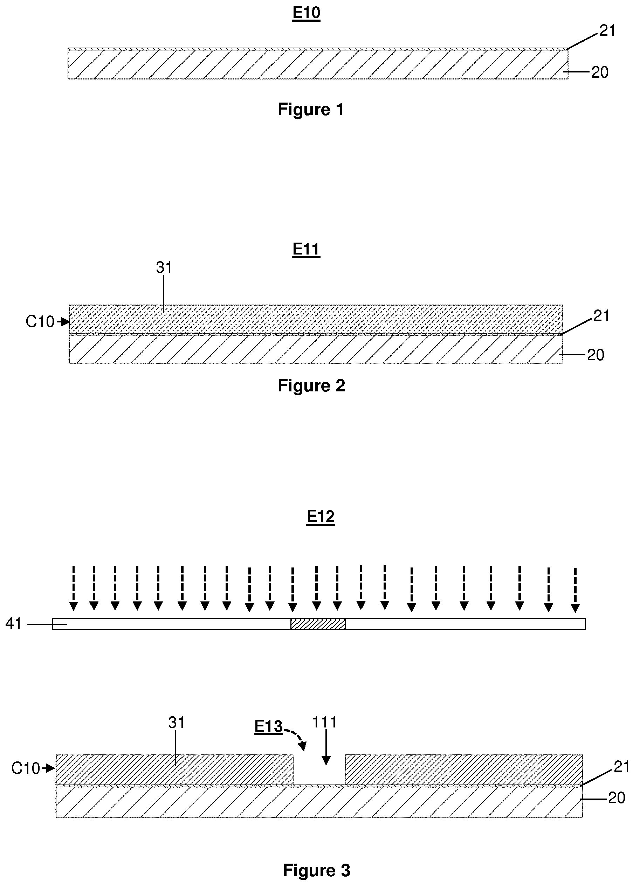

La première sous-étape E10, illustrée par la figure 1, consiste à mettre à disposition un substrat 20. Ce substrat peut être constitué par une plaquette en métal, notamment en alliage comme un acier inoxydable, ou en silicium, ou en verre, ou en une céramique. Ce substrat peut également comporter des structures réalisées par microfabrication. Il est préparé selon les règles connues de l'homme de l'art, notamment pour son dégraissage, nettoyage, éventuellement passivation et/ou activation. Ce substrat est avantageusement plan. En variante, il peut comporter des motifs, notamment des motifs usinés, et/ou des cavités, et/ou d'autres structures, selon les enseignements de l'art antérieur. Préférentiellement, le substrat est muni de repères de sorte à pouvoir être positionné très précisément lors des différentes étapes. Le substrat 20 est dans un matériau conducteur, par exemple en acier inoxydable. En variante, on pourrait aussi utiliser un substrat en un matériau semi-conducteur, comme par exemple le silicium, voire isolant électrique, comme par exemple une céramique.

Optionnellement, comme illustré par la figure 1, une couche conductrice 21 est déposée sur le substrat 20, par exemple par évaporation thermique. Cette couche conductrice 21 est notamment destinée à jouer le rôle d'électrode pour l'amorçage d'un dépôt galvanique, ou électrodéposition, ou électroformage, lors de la réalisation de l'étape E2. De façon connue, cette couche conductrice 21 d'amorçage peut comprendre une sous-couche de chrome, de nickel ou de titane recouverte d'une couche d'or ou de cuivre, et peut ainsi se présenter sous la forme d'une structure multicouche.

Le substrat susmentionné sert de support à la fabrication du moule qui va maintenant être détaillée. Pour simplifier la description, nous utiliserons l'adjectif « longitudinal » pour désigner une des directions parallèles au plan du substrat, et « vertical » pour désigner une des directions perpendiculaires au plan du substrat. Le moule va être construit par l'empilement dans la direction verticale de plusieurs couches longitudinales. De même, nous utiliserons l'adjectif « supérieur » pour désigner une zone ou une surface superposée à une zone ou une surface « inférieure » orientée du côté du substrat, relativement à la direction verticale.

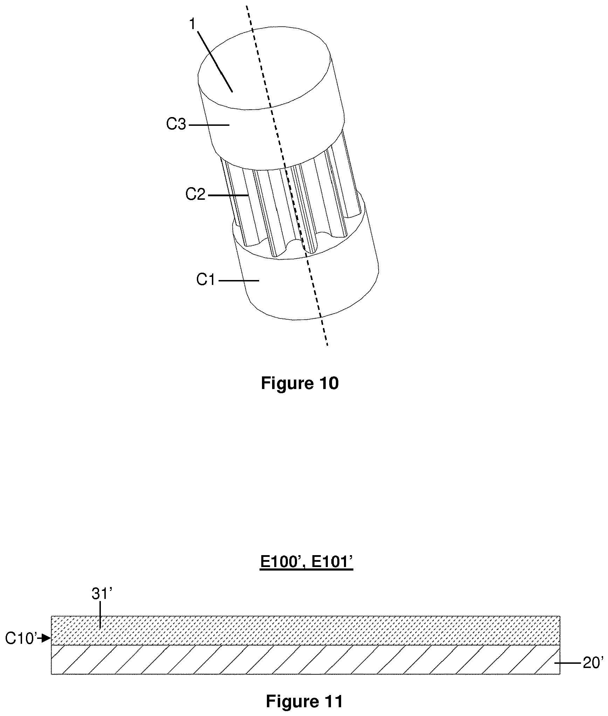

Dans une deuxième sous-étape E11, illustrée par la figure 2, le substrat 20, notamment la couche conductrice 21 optionnelle, est recouvert d'une première couche C10 d'une première résine 31 photosensible sur une hauteur définie, correspondant ou correspondant sensiblement à la hauteur d'une portion C1 du composant horloger 1 à fabriquer, comme cela sera détaillé par la suite en référence avec la figure 10. Cette résine est déposée selon les règles connues de l'homme de l'art, par exemple par « spin coating » ou « déposition par rotation ».

La première résine 31 est une résine photosensible, adaptée à la photolithographie. Cette résine peut être négative ou positive. Dans le premier cas, elle est conçue pour devenir insoluble ou difficilement soluble à un révélateur sous l'action d'un rayonnement (i.e. les zones exposées résistent au développement), alors que, dans le second cas, elle est conçue pour devenir soluble à un révélateur sous l'action d'un rayonnement, alors que la partie non exposée au rayonnement reste insoluble ou difficilement soluble. Dans une variante de réalisation avantageuse de la deuxième sous-étape E11, la résine 31 utilisée est de type « SU-8 », qui est une résine photosensible négative qui polymérise sous l'action d'un rayonnement UV, par exemple la résine SU-8-100 de la maison Microchem.

En alternative, la première résine 31 peut se présenter sous la forme d'un film sec de résine, qui est appliqué sur le substrat 20, notamment sur la couche conductrice 21 optionnelle, de sorte à définir une première couche C10 d'une première résine 31 photosensible. Ce film sec est notamment appliqué par laminage. Ce film sec de résine peut, par exemple, être un film SUEX ou ADEX de la maison DJ Microlaminates Inc. ou un film TMMF S2000 de la maison Tokyo Ohka Kogyo Co. Ces trois films sont des films secs de résine négative.

Une troisième sous-étape E12 de photolithographie de la couche de résine 31 est ensuite réalisée, illustrée par la figure 3. Celle-ci consiste à exposer à une radiation lumineuse ou insoler la première couche C10 de première résine 31 à travers un premier masque 41 comprenant des ouvertures et des zones opaques. Ce masque définit le motif à reproduire pour la réalisation de la portion du composant horloger correspondant à la hauteur de cette première couche. Les radiations lumineuses utilisées pour irradier ou insoler la résine 31 sont ici des rayonnements UV. On pourrait toutefois envisager d'utiliser des rayons X, un faisceau d'électrons (on parle alors de lithographie par faisceau d'électrons) ou tout autre type de radiations adaptées à la résine utilisée. Les rayonnements sont perpendiculaires au plan dans lequel s'étend le masque de manière à n'irradier que les zones de la résine situées au droit des ouvertures ménagées dans le masque. Ces zones sont ainsi définies par des parois verticales ou sensiblement verticales, à savoir perpendiculaires ou sensiblement perpendiculaires au plan du substrat 20. Alternativement, un masque à variation de transmittance peut être employé de sorte à former des parois non verticales ou inclinées desdites zones.

Cette sous-étape E12 est suivie optionnellement d'une étape de traitement thermique de réticulation de la résine 31.

Une quatrième sous-étape E13 de développement est ensuite effectuée, comme illustrée sur la figure 3. Dans l'exemple illustré, la première couche C10 de première résine 31 est ainsi localement dissoute pour former dans la résine une première ouverture 111 débouchante. Par «ouverture débouchante », nous entendons une ouverture débouchant sur l'extérieur vers la direction d'une l'entrée 110 d'une cavité 11 du moule, qui sera précisée par la suite. Par ailleurs, une telle ouverture comprend un fond vers la direction opposée à celle de l'entrée 110 de la cavité 11 du moule. En variante, la première couche C10 pourrait naturellement comprendre plusieurs ouvertures. Dans le cas de cet exemple, où la résine 31 est négative, le développement consiste à éliminer les zones de résine non exposées selon un procédé adapté à la résine 31, par exemple par dissolution avec un produit chimique ou par un procédé plasma. Dans le cas d'une résine photosensible positive qui pourrait être utilisée en variante, les zones insolées sont éliminées lors du développement, par exemple par voie chimique, et les zones non insolées sont conservées sur le substrat. Après dissolution, le substrat 20 ou l'optionnelle couche conductrice 21 apparaît aux endroits où la première résine 31 a été éliminée.

Les parties restantes de première résine 31 forment ainsi une première couche C10 du moule 10, comme cela sera précisé par la suite, qui comprend un premier volume formé par la première ouverture 111. Le fond de cette ouverture est délimité par le substrat 20 ou l'éventuelle couche conductrice 21.

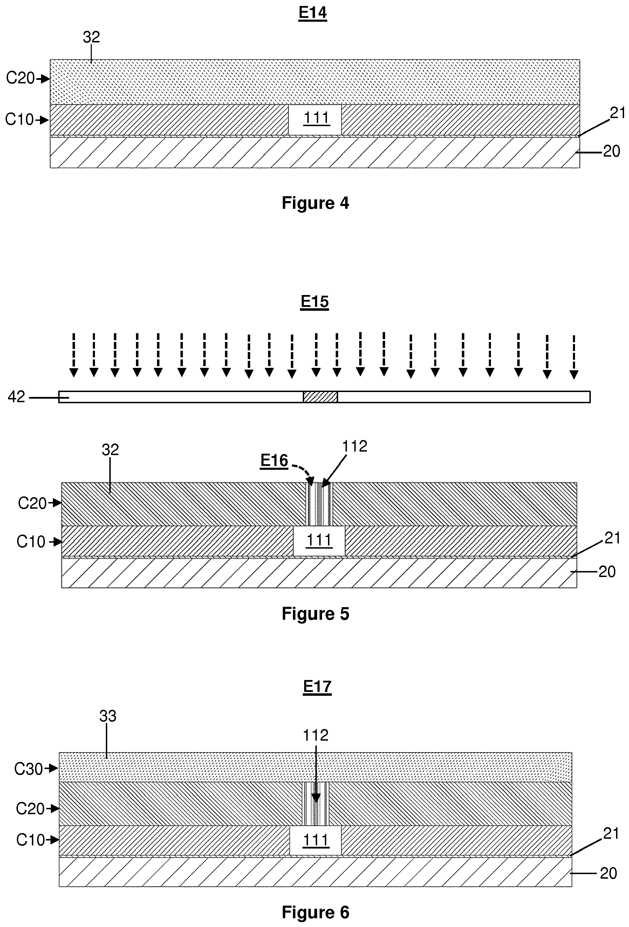

Une cinquième sous-étape E14, illustrée par la figure 4, consiste à recouvrir la première couche C10 de première résine 31 d'une deuxième couche C20 d'une deuxième résine 32.

Cette deuxième résine 32 présente la spécificité de se présenter sous la forme d'un film sec, qui est appliqué sur la première couche C10 de sorte à définir une deuxième couche C20 de deuxième résine 32 photosensible, dont la hauteur correspond ou correspond sensiblement à la hauteur d'une deuxième couche C2 du composant horloger à fabriquer, comme cela sera détaillé en référence avec la figure 10. Ce film sec est notamment appliqué par laminage.

L'emploi d'un tel film, du fait de sa rigidité, permet avantageusement de positionner précisément la deuxième résine 32 par-dessus la première ouverture 111 de la première couche de première résine, notamment selon la direction verticale. Avantageusement, un tel film est autoportant, c'est-à-dire que son intégrité géométrique est assurée par sa seule rigidité. Autrement dit, un tel film est rigide. Plus particulièrement, selon le mode de réalisation, le module d'élasticité d'un tel film est compris entre 2 et 5 GPa (à 20°C). Ainsi, l'emploi d'un tel film permet avantageusement la formation d'une deuxième couche C20 de deuxième résine 32, dont une surface longitudinale n'est pas entièrement superposée à une surface longitudinale d'une première couche C10 de première résine 31 lors de la cinquième sous-étape E14. Avantageusement, une telle surface longitudinale non entièrement superposée à une surface longitudinale d'une première couche C10 de première résine 31 ne se déforme pas sous l'effet de la gravité dans sa partie non supportée par la première couche et peut ainsi être positionnée précisément, notamment selon la direction verticale.

Le film de résine peut être, par exemple, un film SUEX ou ADEX de la maison DJ Microlaminates Inc. ou un film TMMF S2000 de la maison Tokyo Ohka Kogyo Co. L'épaisseur du film peut être comprise entre 100 µm et 1 mm.

Une sixième sous-étape E15 de photolithographie de la deuxième couche de deuxième résine 32 est ensuite réalisée, comme illustré par la figure 5. Celle-ci consiste à exposer à une radiation lumineuse ou insoler la deuxième couche de deuxième résine 32 à travers un deuxième masque 42 comprenant des ouvertures et des zones opaques. Ce masque définit le motif à reproduire pour la réalisation d'une autre portion C2 du composant horloger, comme cela sera détaillé par la suite en référence avec la figure 10.

Cette sous-étape E15 est suivie optionnellement d'une étape de traitement thermique de réticulation de la deuxième résine 32.

Une septième sous-étape E16 de développement est ensuite effectuée, comme illustrée par la figure 5. Dans le cas de l'exemple illustré, où la deuxième résine 32 est négative, le développement consiste à éliminer les zones de deuxième résine non exposées, selon un procédé adapté à cette deuxième résine 32, par exemple par dissolution avec un produit chimique ou par un procédé plasma.

Après dissolution, selon l'exemple représenté dans ce mode de réalisation, une deuxième ouverture 112 traversante est formée dans la deuxième couche C20 du moule, aux endroits où la résine a été éliminée. Cette deuxième ouverture 112 traversante est au moins partiellement superposée à la première ouverture 111. Par « ouverture traversante », nous entendons une ouverture qui traverse de part en part la couche dans laquelle elle est formée, dans une direction verticale. Autrement dit, une telle ouverture débouche notamment vers la direction de l'entrée 110 de la cavité 11 du moule 10, comme cela sera précisé par la suite, et vers la première ouverture 111. Une telle ouverture ne comprend pas de fond.

Les parties restantes de résine forment ainsi une deuxième couche C20, dont la deuxième ouverture 112 forme un deuxième volume de la cavité 11 du moule 10, en complément du premier volume formé par la première ouverture 111.

La géométrie ainsi formée présente la particularité que d'une part, la deuxième ouverture 112 traversante de la deuxième couche C20 est superposée à la première ouverture 111 débouchante de la première couche C10, formant un volume continu d'une cavité d'un futur moule, et que d'autre part, la deuxième couche C20 en résine recouvre partiellement cette même première ouverture 111 débouchante de la première couche en résine. Autrement dit, le contour de la deuxième couche C20 au niveau de la deuxième ouverture 112 fait saillie à l'intérieur de l'élévation verticale du contour formé par la première ouverture 111. Le film sec de deuxième résine 32 présente la rigidité suffisante pour supporter ce positionnement partiellement au-dessus du vide au niveau de la première ouverture 111.

Dans le mode de réalisation décrit, les deux ouvertures 111, 112 superposées sont centrées, notamment coaxiales. La deuxième ouverture 112 présente une section de superficie inférieure à la section de la première ouverture 111. Bien entendu, selon un mode de réalisation alternatif, les deux ouvertures 111, 112 peuvent être au moins partiellement superposées sans être centrées.

Le procédé de fabrication d'un moule selon ce premier mode de réalisation comprend une huitième sous-étape E17, illustrée par la figure 6, qui consiste à recouvrir la deuxième couche C20 de deuxième résine 32 d'une troisième couche C30 supérieure d'une troisième résine 33.

Cette troisième résine 33 peut se présenter sous la forme d'un film sec, qui est appliqué, en particulier par laminage, sur la deuxième couche C20 de sorte à définir une troisième couche C30 de troisième résine 33 photosensible, dont la hauteur correspond ou correspond sensiblement à la hauteur de la portion C3 du composant horloger à fabriquer, comme cela sera détaillé en référence avec la figure 10. Alternativement, cette troisième résine 33 peut être déposée sur une hauteur souhaitée, selon les règles connues de l'homme de l'art, par exemple par « spin coating » ou « déposition par rotation ».

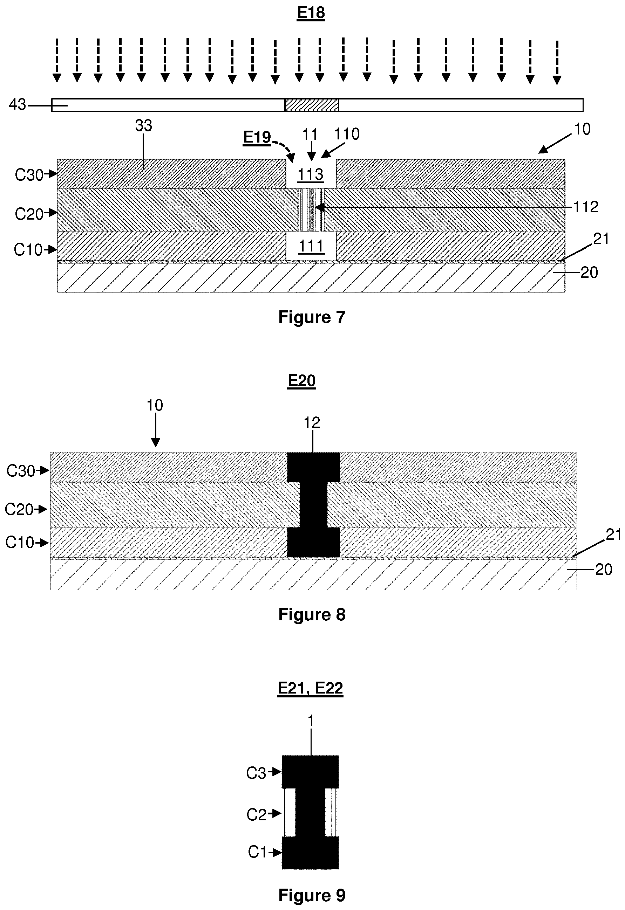

Une neuvième sous-étape E18 de photolithographie de la troisième couche de résine 33 est ensuite réalisée, illustrée par la figure 7. Celle-ci consiste à exposer à une radiation lumineuse ou insoler la couche de résine 33 à travers un troisième masque 43 comprenant des ouvertures et des zones opaques. Ce masque définit le motif à reproduire pour la réalisation de la portion du composant horloger correspondant à la hauteur de cette troisième couche, selon l'exemple choisi.

Cette sous-étape E18 est suivie optionnellement d'une étape de traitement thermique de réticulation de la troisième résine 33.

Une dixième sous-étape E19 de développement, toujours illustrée par la figure 7, est ensuite effectuée. Dans le cas de l'exemple de ce mode de réalisation, où la résine 33 est négative, le développement consiste à éliminer les zones de résine non exposées selon un procédé adapté à la résine 33, par exemple par dissolution avec un produit chimique ou par un procédé plasma.

Les parties restantes de résine forment ainsi une troisième couche C30 du moule, qui comprend, selon l'exemple choisi, une troisième ouverture 113 traversante, superposée au moins partiellement aux deux premières ouvertures 111, 112. Cette troisième ouverture forme un troisième volume de la cavité du moule.

Ainsi, les trois ouvertures 111, 112, 113 sont superposées, au moins partiellement, pour former une cavité 11. Il résulte des étapes E10 à E19 un moule 10 en résine, multicouche, comprenant une cavité 11 dotée d'une entrée 110. Le volume de cette cavité 11 correspond aux trois volumes correspondant respectivement aux trois ouvertures 111, 112, 113 des trois couches C10, C20, C30. Tout ou partie de cette cavité 11 est destinée à être remplie lors d'une deuxième étape E2 décrite ci-après.

L'invention porte également sur un procédé de fabrication d'un composant horloger à partir du moule formé précédemment, selon le procédé de fabrication d'un moule qui forme la première étape E1 du procédé de fabrication du composant horloger selon ce premier mode de réalisation de l'invention.

Le procédé de fabrication du composant horloger comprend ensuite une deuxième étape E2 dont les sous-étapes vont être détaillées ci-après.

Une première sous-étape E20 consiste à remplir tout ou partie de la cavité du moule 10 d'un métal 12, par électrodéposition, électroformage, ou dépôt galvanique.

La couche conductrice 21 ou directement le substrat 20 joue le rôle de cathode pour amorcer la sous-étape E20. Cette sous-étape utilise, par exemple, le procédé LIGA et un métal ou un alliage de métal 12 tel que, par exemple, le nickel (Ni) ou le nickel-phosphore (NiP). Avantageusement, un alliage tel que celui décrit au sein de la demande de brevet WO2017102661 peut être employé. Ce métal ou alliage métallique 12 est déposé dans tout ou partie de la cavité 11 du moule 10 par l'intermédiaire de son entrée 110, formée à la surface supérieure de la troisième ouverture 113 de la troisième couche C30.

Cette sous-étape E20 est de préférence prolongée jusqu'au remplissage de toute la hauteur de la cavité 11 du moule 10, comme illustré par la figure 8, ce qui présente l'avantage de permettre la croissance d'un seul tenant d'un métal ou d'un alliage métallique à l'intérieur des trois volumes formés par les ouvertures 111, 112, 113 de la cavité 11 du moule 10. Ainsi, à la différence des composants résultant des procédés de fabrication des demandes de brevet EP2004881 et EP2405301, le composant horloger formé à l'aide du moule 10 résulte d'une seule et unique étape de croissance d'un métal ou d'un alliage métallique. Par ailleurs, le composant horloger présente sur ses surfaces fonctionnelles une définition, en particulier état de surface, contrôlée correspondant à celles de tout ou partie des surfaces de la cavité 11 du moule 10.

De plus, le composant horloger obtenu a préférentiellement la même hauteur que celle correspondant à l'empilement des trois couches C10, C20, C30 du moule 10.

De façon optionnelle, cette sous-étape E20 peut comprendre une mise d'épaisseur, par polissage mécanique simultané de la couche métallique et du moule 10, pour obtenir une surface supérieure parfaitement plane, horizontale, et dont l'état de surface est satisfaisant.

Le procédé comprend ensuite une sous-étape E21 de détachement du matériau métallique 12 et de son moule 10 du substrat 20, par exemple par délamination de la couche 21 du substrat.

Une sous-étape finale E22 permet finalement de séparer le composant horloger 1 formé par le dépôt métallique dans la cavité 11 du moule 10, par exemple par attaque chimique de la ou des résines formant le moule 10, ou à l'aide d'un plasma. On libère ainsi le composant horloger 1, comme illustré par la figure 9.

Un composant horloger 1 obtenu selon un exemple d'implémentation du premier mode de réalisation décrit ci-dessus est illustré plus en détail sur la figure 10. Ce composant horloger 1 est un pignon arbré. Il comprend trois portions C1, C2, C3, respectivement moulées dans les trois ouvertures 111, 112, 113 de la cavité 11 du moule 10 décrit précédemment. Les deux portions C1, C3 d'extrémité sont des cylindres, similaires, de même diamètre et de même hauteur, et coaxialement agencés. Une zone intermédiaire C2 forme un pignon intégré dans l'arbre formé par les cylindres des portions C1, C3. Cette zone intermédiaire C2 est inscrite dans le cylindre défini par le prolongement des portions C1, C3. Cette zone intermédiaire C2 forme le pignon du composant horloger 1, et est définie lors de la fabrication par le deuxième volume formé par la deuxième ouverture 112 de la deuxième couche C20 du moule 10, qui présente donc la géométrie correspondant au pignon à fabriquer, notamment aux dents à former. De plus, cette portion intermédiaire C2 présente une section de superficie inférieure à celles des portions C1, C3.

Un premier avantage du procédé de fabrication du composant horloger 1 décrit précédemment est de permettre l'obtention d'un composant horloger 1 multiniveau se présentant d'un seul tenant, totalement monobloc et homogène. Dans l'exemple réalisé, il est formé en une seule étape d'électroformage, en opposition aux procédés de l'état de la technique qui reposent sur des dépôts galvaniques distincts ou des étapes d'électroformages successives, réalisés séparément couche par couche, ce qui engendre une structure multicouche non homogène comprenant des zones de fragilité à la jointure entre les différentes couches du composant horloger final. D'autre part, on note que la partie fonctionnelle du composant horloger 1, formée par la portion intermédiaire C2, présente un contour parfaitement défini par une ou des surfaces de la cavité 11 du moule 10 sur les parois verticales latérales, et de même parfaitement défini sur ses surfaces longitudinales supérieure et inférieure puisqu'elles sont délimitées par les portions C1, C3 du composant, elles-mêmes définies avec précision par une ou des surfaces de la cavité 11 du moule 10. Ainsi, il n'y a aucun besoin de reprise finale du composant horloger 1 après sortie du moule pour améliorer la définition, notamment l'état de surface, de la partie fonctionnelle de la portion C2. Le procédé permet ainsi d'obtenir un composant horloger fiable de manière simplifiée.

En remarque, le composant horloger a été décrit à partir d'un dépôt galvanique au sein de la cavité 11 du moule 10. En variante, le composant horloger peut se présenter en un autre matériau, comme un composite à matrice métallique ou à matrice polymérique. Ce composant horloger peut de plus en variante être formé par tout autre procédé de remplissage au sein de la cavité du moule qu'un dépôt galvanique.

Naturellement, l'invention ne se limite pas au premier mode de réalisation décrit ci-dessus. Selon un deuxième mode de réalisation, le procédé peut comprendre une étape d'ajout d'un insert dans au moins une partie de la cavité du moule obtenu selon un procédé semblable à celui décrit précédemment, suivie d'une étape de fabrication d'une partie du composant horloger par remplissage d'une partie de la cavité du moule, de manière similaire au premier mode de réalisation, permettant non seulement de fabriquer ladite partie du composant horloger 1 mais aussi de la solidariser à l'insert, formant ainsi un composant horloger final composé de l'insert et de la partie solidarisée à l'insert, cette partie enserrant l'insert. Avantageusement, un tel insert se présente dans un matériau différent de celui de la partie du composant horloger obtenu par remplissage d'une partie de la cavité du moule.

Ce deuxième mode de réalisation va maintenant être décrit plus en détail.

Selon ce deuxième mode de réalisation, l'invention repose également en premier lieu sur un procédé de fabrication d'un moule multicouche en résine par photolithographie, qui constitue une première étape E1' du procédé de fabrication du composant horloger selon le second mode de réalisation.

Les deux premières sous-étapes, illustrées par la figure 11, consistent d'une part en une sous-étape E100' de mise à disposition d'un substrat, et d'autre part en une sous-étape E101' de réalisation d'une couche inférieure C10' en résine 31'. Ces deux sous-étapes sont semblables aux deux premières sous-étapes E10, E11 du premier mode de réalisation et ne seront pas décrites de nouveau. En remarque, dans l'exemple illustré, le substrat 20' ne comprend pas de couche intermédiaire optionnelle 21.

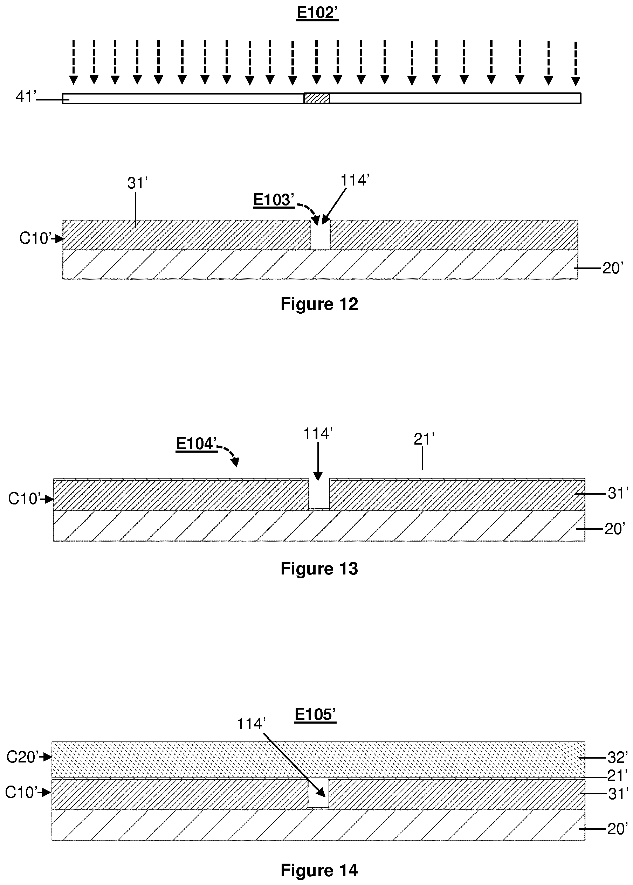

Le procédé comprend ensuite deux sous-étapes E102', E103', illustrées par la figure 12 qui correspondent de même aux deux sous-étapes E12, E13 du premier mode de réalisation et ne seront pas décrites de nouveau. A l'issue de ces sous-étapes, une ouverture 114' inférieure débouchante est formée dans la couche inférieure C10', qui formera un volume inférieur de la cavité du futur moule.

Le procédé comprend une cinquième sous-étape E104' de métallisation de la surface supérieure de la couche inférieure C10' de résine 31', comme illustré par la figure 13. Plus particulièrement, cette sous-étape consiste à déposer une couche conductrice 21', qui est notamment destinée à jouer le rôle d'électrode pour l'amorçage d'un dépôt galvanique, ou électrodéposition ou électroformage, lors de la réalisation de la deuxième étape E2' qui sera décrite ultérieurement. De façon connue, cette couche conductrice 21' d'amorçage peut comprendre une sous-couche de chrome, de nickel ou de titane recouverte d'une couche d'or ou de cuivre, et peut ainsi se présenter sous la forme d'une structure multicouche. Cette couche conductrice 21' recouvre non seulement la surface de cette couche inférieure C10' mais peut aussi recouvrir le fond de l'ouverture 114', c'est-à-dire la surface du substrat 20' dans l'exemple illustré, voire les flancs de l'ouverture 114'.

Le procédé comprend une sixième sous-étape E105', illustrée par la figure 14, qui consiste à former une première couche C20' avec une première résine 32' photosensible sur la couche conductrice 21', sur une hauteur souhaitée.

Cette première résine 32' peut se présenter sous la forme d'un film sec, qui est appliqué, notamment par laminage, sur la couche conductrice 21'. Ce film de résine peut être, par exemple, un film SUEX ou ADEX de la maison DJ Microlaminates Inc. ou un film TMMF S2000 de la maison Tokyo Ohka Kogyo Co. Ces trois films sont des films de résine négative. Alternativement, cette première résine 32' peut être déposée sur une hauteur souhaitée, selon les règles connues de l'homme de l'art, par exemple par « spin coating » ou « déposition par rotation ». En variante, la première résine 32' est de type « SU-8 », qui est une résine photosensible négative qui polymérise sous l'action d'un rayonnement UV, par exemple la résine SU-8-100 de la maison Microchem.

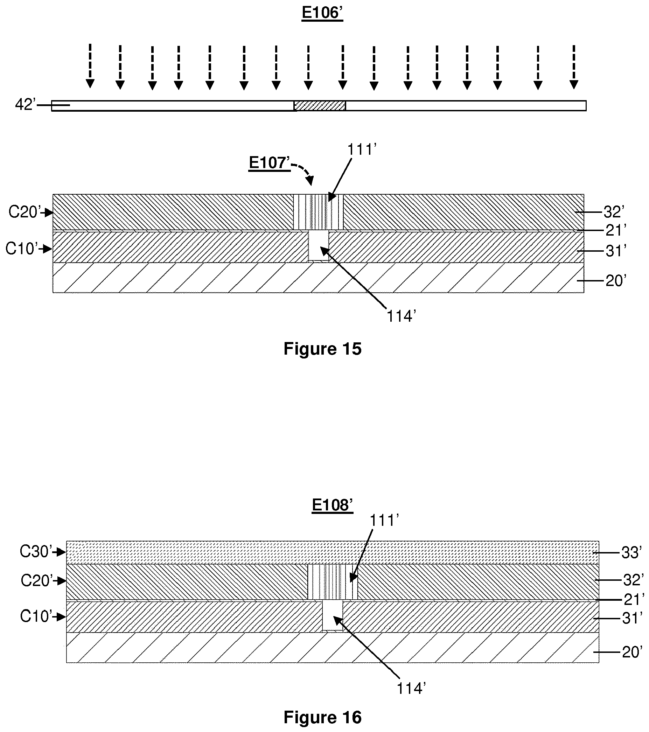

Le procédé comprend ensuite deux sous-étapes E106', E107' illustrées par la figure 15, qui correspondent sensiblement aux deux sous-étapes E18, E19 du premier mode de réalisation. Elles permettent de former une première ouverture 111' traversante dans la première couche C20', qui formera un premier volume de la cavité 11' du moule 10', en complément du volume formé par l'ouverture 114' inférieure.

Le procédé comprend ensuite une neuvième sous-étape E108', qui consiste à recouvrir la première couche C20' de première résine 32' d'une deuxième couche C30' de deuxième résine 33', comme illustré par la figure 16.

Cette deuxième résine 33' présente la spécificité de se présenter sous la forme d'un film sec, qui est appliqué, notamment par laminage, sur la deuxième couche C20', de sorte à définir une deuxième couche C30' de deuxième résine 33' photosensible selon une hauteur prédéfinie. L'emploi d'un tel film, de par sa rigidité, permet avantageusement de positionner précisément la deuxième résine 33' par-dessus la première ouverture 111' formée dans la première couche C20', notamment selon la direction verticale, comme cela sera détaillé ci-après. Avantageusement, un tel film est autoportant, c'est-à-dire que son intégrité géométrique est assurée par sa seule rigidité. Autrement dit, un tel film est rigide. Plus particulièrement, le module d'élasticité d'un tel film est avantageusement compris entre 2 et 5 GPa (à 20°C). L'épaisseur du film peut être comprise entre 100 µm et 1 mm.

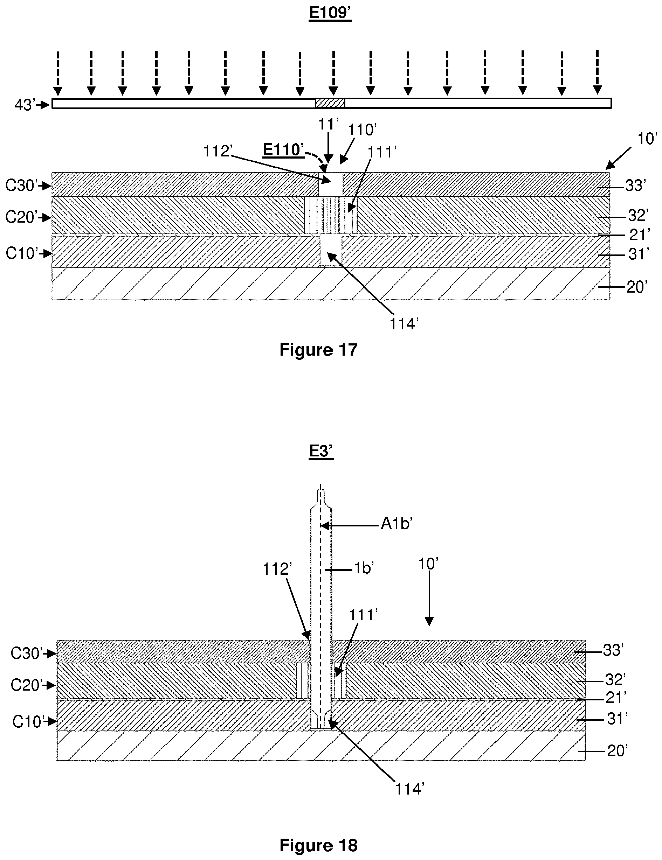

Le procédé comprend ensuite deux sous-étapes E109', E110', illustrées par la figure 17, qui permettent de former une deuxième ouverture 112' traversante dans la deuxième couche C30', de manière similaire aux deux sous-étapes E15, E16 du premier mode de réalisation. Elle forme un deuxième volume de la cavité 11' du moule 10'.

Finalement, les trois ouvertures 114', 111', 112' forment respectivement trois volumes correspondant au volume d'une cavité 11' d'un moule 10'. Autrement dit, elles sont superposées, au moins partiellement, pour former une cavité 11'.

La géométrie ainsi formée présente la particularité, comme dans le premier mode de réalisation, que d'une part, la deuxième ouverture 112' traversante de la deuxième couche C30' est superposée à la première ouverture 111' traversante de la première couche C20' et que d'autre part, la deuxième couche C30' en résine recouvre partiellement cette même première ouverture 111' traversante de la première couche en résine. Autrement dit, le contour de la deuxième couche C30' au niveau de la deuxième ouverture 112' fait saillie à l'intérieur de l'élévation verticale du contour formé par la première ouverture 111'. La deuxième résine 33' présente la rigidité suffisante pour supporter ce positionnement partiellement au-dessus du vide au niveau de la première ouverture 111'.

Dans le mode de réalisation décrit, les deux ouvertures 111', 112' superposées sont centrées, en particulier coaxiales. La deuxième ouverture 112' présente une section de superficie inférieure à la section de la première ouverture 111'. Bien entendu, selon un mode de réalisation alternatif, les deux ouvertures 111', 112' peuvent être au moins partiellement superposées sans être centrées.

Il résulte des étapes E100' à E110' un moule en résine 10' multicouche comprenant une cavité 11' dotée d'une entrée 110'. Le volume de cette cavité 11' correspond aux trois volumes correspondant respectivement aux trois ouvertures 114', 111', 112' de respectivement les trois couches C10', C20', C30'.

L'invention porte également sur un procédé de fabrication d'un composant horloger à partir du moule formé précédemment, selon le procédé de fabrication d'un moule qui forme la première étape E1' du procédé de fabrication du composant horloger selon ce deuxième mode de réalisation de l'invention.

Selon ce deuxième mode de réalisation, le procédé de fabrication du composant horloger comprend une étape intermédiaire E3' d'insertion d'un élément ou d'un insert dans une partie de la cavité du moule, puis une deuxième étape E2' de remplissage d'une partie de la cavité du moule qui s'apparente à la deuxième étape E2 du premier mode de réalisation. Les sous-étapes de ces étapes de fabrication vont maintenant être détaillées ci-après.

Selon le deuxième mode de réalisation illustré, une portion d'un élément 1b', un arbre dans cet exemple, est inséré au travers les trois ouvertures 112', 111', 114' du moule 10', comme illustré par la figure 18. Pour cela, l'ouverture inférieure 114' de la couche inférieure C10' du moule 10' présente préférentiellement une section présentant un format sensiblement équivalent au format d'une section de la portion insérée de l'élément 1b', notamment une section circulaire présentant un diamètre sensiblement équivalent au diamètre d'une section de la portion insérée de l'élément 1b'. Préférentiellement, cette portion d'arbre insérée est chassée dans cette ouverture inférieure 114' de sorte à ajuster l'arbre à moindre jeu dans la cavité 11' du moule 10', tout en faisant en sorte que l'axe A1b' de l'arbre soit perpendiculaire au plan du substrat 20' selon les tolérances d'assemblage prescrites. Avantageusement, cette insertion en chassant l'arbre au sein de la couche dans une résine inférieure 31' de type « SU-8 » permet d'obtenir un maintien performant de l'arbre pour la suite du procédé.

Dans cet exemple de réalisation, la portion insérée de l'arbre 1b' présente de plus un diamètre égal au diamètre d'une portion de réception 10b' de l'arbre 1b' prévue pour réceptionner la partie 1a' qui va être réalisée par la suite, comme cela sera détaillé plus bas. Bien entendu, ces deux portions de l'arbre pourraient présenter des diamètres et/ou des formes différents.

De plus, dans cet exemple de réalisation, l'axe est chassé en butée à l'encontre du substrat 20', en particulier à l'encontre d'une couche métallique 21' sur le substrat 20' créée lors de l'étape E104'. Alternativement, le substrat 20' pourrait présenter une ouverture sous l'ouverture inférieure 114', prévue pour laisser passer une portion d'arbre, en particulier une portion de guidage de l'arbre, notamment un pivot de l'arbre.

Dans cet exemple de réalisation, l'élément 1b', qui forme un insert dans ce procédé, est préalablement usiné dans son intégralité avant l'étape intermédiaire E3'. Autrement dit, l'élément présente un état fini lors de son assemblage au sein du moule 10' durant l'étape intermédiaire E3'. Alternativement, il pourrait présenter un état intermédiaire lors de son assemblage au sein d'une partie la cavité 11' du moule 10' durant l'étape intermédiaire E3', et être terminé a posteriori de la deuxième étape E2'.

En complément, la deuxième ouverture 112' de la deuxième couche C30' présente aussi une forme qui correspond sensiblement au diamètre de l'élément 1b'. Une fois cet élément 1b' disposé dans une partie de la cavité 11' du moule 10', la première ouverture 111', qui est disposée entre les deux ouvertures inférieure 114' et supérieure 112' (c'est-à-dire la deuxième ouverture), est quasi fermée, aux jeux respectifs près définis entre l'élément 1b' et ces deux ouvertures 114', 112'. Plus précisément, la première ouverture 111' est fermée sur ses parois latérales verticales par la première couche C20', fermée sur ses parois verticales centrales par l'élément 1b', fermée sur sa surface inférieure longitudinale par la surface supérieure longitudinale de la couche inférieure C10' (plus exactement la couche métallisée 21' déposée sur cette couche inférieure C10') et sur sa surface supérieure longitudinale par la surface inférieure longitudinale de la deuxième couche C30'.

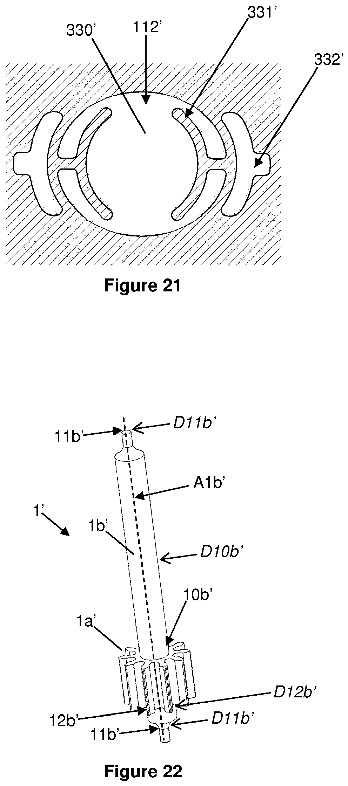

La deuxième étape E2' du procédé a pour but de former une partie 1a' du composant horloger 1', plus particulièrement représenté par la figure 22, à partir du moule 10'. Pour cela, une partie du volume de la cavité 11' du moule 10', en particulier une partie du premier volume défini par la première ouverture 111', c'est-à-dire le volume de la cavité 11' non occupé par l'élément 1b', est remplie d'un matériau, de manière semblable à la deuxième étape E2 du premier mode de réalisation.

La partie 1a' de composant horloger peut être en métal ou en un alliage métallique. Alternativement, cette partie 1a' peut être faite en un composite, par exemple un composite à matrice métallique ou à matrice polymérique.

Selon ce mode de réalisation, la deuxième étape E2' de remplissage comprend les sous-étapes suivantes.

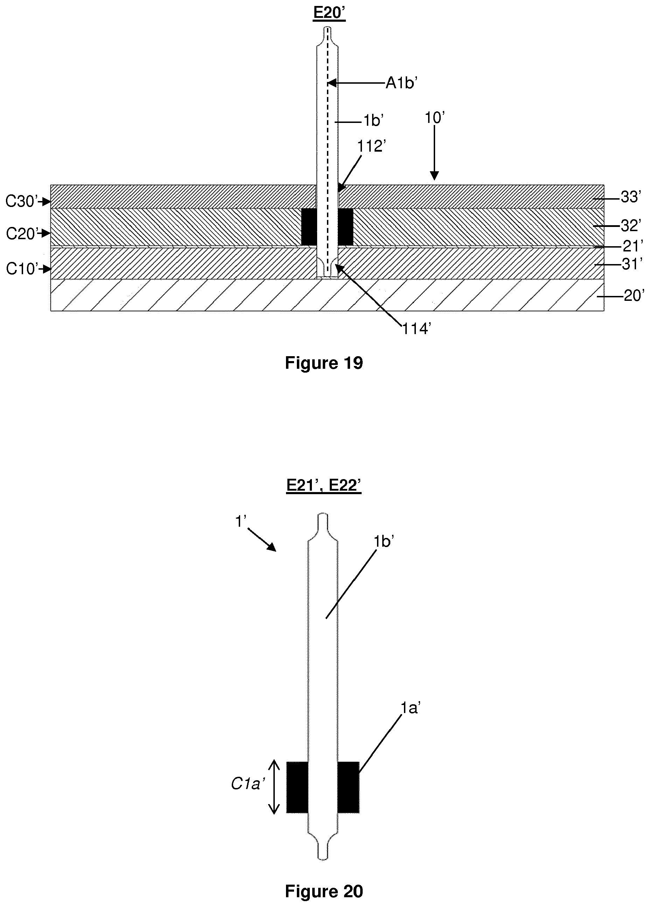

Une première sous-étape E20', illustrée par la figure 19, consiste à déposer un matériau métallique dans une partie de la cavité du moule 10', et donc autour de l'élément 1b', par électrodéposition ou électroformage, ou dépôt galvanique. La partie métallique ainsi électrodéposée ou électroformée, notamment de manière isotrope, présente des contraintes internes de sorte à ce que celle-ci épouse et enserre parfaitement l'élément 1b' pour permettre la tenue de la future partie 1a' du composant horloger 1' sur l'élément 1b'. En remarque, dans cet exemple, le volume de la partie de la cavité 11' du moule 10' à remplir se limite à une partie du volume défini par la première ouverture 111', le reste du volume étant occupé par l'élément 1b' inséré.

Dans cette sous-étape, la couche conductrice 21' joue le rôle de cathode pour amorcer le dépôt. Cette étape utilise, par exemple, le procédé LIGA et un métal ou un alliage de métal tel que, par exemple, le nickel (Ni) ou le nickel-phosphore (NiP). Avantageusement, un alliage tel que celui décrit au sein de la demande de brevet WO2017102661 peut être employé.

Comme mentionné dans le cas du premier mode de réalisation, cette sous-étape E20' présente l'avantage de permettre la croissance de la partie 1a' du composant horloger 1' d'un seul tenant, en un métal ou en un alliage métallique. De plus, ce métal est formé sur une hauteur parfaitement définie par la première couche C20'. Comme la partie de cavité du moule formée par la première ouverture 111' est parfaitement délimitée sur toutes ses surfaces, y compris les surfaces inférieure et supérieure, la partie 1a' est formée avec un excellent état de surface final, y compris sur ses surfaces longitudinales. Notamment, il est intéressant de souligner que la croissance d'un métal ou d'un alliage métallique à l'encontre de la deuxième couche C30' de deuxième résine permet d'obtenir un excellent état de surface de la surface supérieure de la partie 1a'. Ainsi, la présence de la deuxième couche C30' au-dessus d'une partie de la première ouverture 111' permet d'aboutir à la fabrication d'une partie 1a' de composant horloger 1' dont les surfaces fonctionnelles sont parfaitement maîtrisées et terminées, et ce indépendamment de toute reprise mécanique.

De façon optionnelle, la sous-étape E20' peut toutefois comprendre une étape de terminaison au niveau de la jonction entre l'élément 1b' et le métal formant la partie 1a'. Cette étape de terminaison peut, par exemple, être effectuée par le biais d'un laser, notamment d'un laser femto seconde.

Enfin, le procédé comprend des sous-étapes E21', E22' de séparation du composant horloger 1', similaires aux étapes E21, E22 du premier mode de réalisation, par exemple par attaque chimique ou à l'aide d'un plasma, pour atteindre le résultat illustré par la figure 20.

Avantageusement, le motif 330' de la deuxième couche C30' au niveau de la deuxième ouverture 112', illustré par la figure 21, peut présenter une structure élastique 331'. Une telle conformation permet avantageusement de centrer l'élément 1b' et de le maintenir perpendiculaire au substrat 20', en particulier à la couche inférieure C10' de résine 31' au sein de laquelle est prévue d'être disposée la partie 1a'.

En complément ou variante, le motif 330' choisi est avantageusement prévu pour définir un jeu adéquat entre l'élément 1 b' et la deuxième couche C30' de deuxième résine 33', de sorte à permettre le passage de l'électrolyte au sein de la première ouverture 111' lors de la deuxième étape E2'. Ce jeu représente un espace constituant ainsi l'entrée 110' de la cavité 11' du moule. Alternativement ou complémentairement, le motif 330' peut comprendre un ou des trous 332' pour permettre le passage de l'électrolyte. Chaque trou appartient aussi à l'entrée 110' de la cavité 11' du moule. Alternativement ou complémentairement, le moule 10' peut comprendre un ou plusieurs trous disposés dans des plans distincts de celui du motif 330'. Chacun de ces trous appartient aussi à l'entrée 110' de la cavité 11' du moule.

Ce motif 330' de la deuxième couche C30' est formé lors des sous-étapes E109', E110' décrites précédemment, consistant à exposer à une radiation lumineuse ou insoler la deuxième couche de résine 33' à travers un troisième masque 43' comprenant des ouvertures et des zones opaques. Ce masque définit ainsi le motif 330' à reproduire pour permettre le passage de l'électrolyte au sein de la première ouverture 111' lors de la deuxième étape E2'.

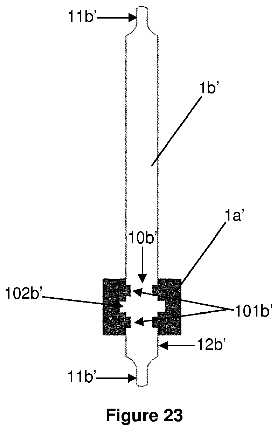

Bien entendu, l'élément 1b' peut présenter des conformations spécifiques pour optimiser la tenue de la partie 1a' sur l'élément 1b', comme illustré par la figure 23. Par exemple, la portion 10b' d'arbre peut présenter des cannelures 101b' qui sont prévues pour optimiser la tenue en couple du pignon sur l'arbre. Lors de l'étape E2', le métal vient par exemple se loger dans ces cannelures 101b'. Alternativement ou complémentairement, la portion 10b' d'arbre peut comprendre une portée 102b' qui est prévue pour maximiser la tenue axiale du pignon sur l'arbre. Alternativement ou complémentairement, la portion 10b' d'arbre peut comprendre une structuration de surface dans le but d'augmenter localement la rugosité afin d'optimiser le maintien du pignon sur l'arbre.

Un composant horloger 1' obtenu selon un exemple d'implémentation du deuxième mode de réalisation décrit ci-dessus est illustré plus en détail sur la figure 22. Ce composant horloger 1' est un pignon arbré. L'arbre est formé par l'insert mentionné précédemment et le pignon correspond à la partie 1a' fabriquée autour d'une portion de l'arbre inséré. Ainsi, le composant horloger 1' comprend avantageusement une première partie 1a', ici un pignon, se présentant avantageusement en un premier matériau métallique, et une deuxième portion correspondant à l'élément 1b', ici un arbre, se présentant en un deuxième matériau, de préférence non-conducteur et différent du premier matériau.

L'arbre du composant horloger 1' traverse ici le pignon de part en part. L'arbre peut, par exemple, être fabriqué en un matériau non conducteur, par exemple une céramique, notamment une zircone, en particulier une zircone yttriée, notamment une zircone yttriée 3%, ou une alumine monocristalline, ou une combinaison alumine-zircone. Alternativement, l'arbre du composant horloger peut être fabriqué en un matériau composite.

L'arbre comprend une portion de réception 10b' du pignon, dont une section présente un premier diamètre D10b'. Avantageusement, l'arbre comprend également au moins une portion de guidage 11b' du pignon arbré 1', préférentiellement deux portions de guidage 11b', notamment deux pivots 11b', dont une section présente un deuxième diamètre D11b'. Préférentiellement, le deuxième diamètre D11b' est inférieur, voire très inférieur au premier diamètre D10b'.

De par les propriétés intrinsèques des céramiques citées précédemment, qui sont extrêmement dures, les pivots de l'arbre ne se marquent pas lors des chocs. Avantageusement, en cas de choc important, ces pivots ne se déformeront pas, a contrario des pivots en acier qui peuvent plier et de ce fait porter atteinte à la chronométrie et/ou à la fonctionnalité du mouvement horloger. Par ailleurs, les céramiques offrent l'avantage supplémentaire d'être particulièrement peu sensibles aux champs magnétiques, et de ne pas influencer la marche de la pièce d'horlogerie lorsqu'elle est soumise à un champ magnétique, notamment un champ magnétique supérieur à 80 kA/m (1000G).

Préférentiellement, le premier diamètre D10b' est inférieur à 2 mm, voire inférieur à 1 mm, voire inférieur à 0.5 mm, voire inférieur à 0.3 mm, et le diamètre D10b' est supérieur à 0.1 mm, voire supérieur à 0.2 mm.

Préférentiellement, le deuxième diamètre D11b' est inférieur à 0.5 mm, voire inférieur à 0.4 mm, voire inférieur à 0.2 mm, voire inférieur à 0.1 mm, voire inférieur à 0.08 mm, et le deuxième diamètre D11b' est supérieur à 0.03 mm, voire supérieur à 0.05 mm.

Préférentiellement encore, le rapport D10b'/D11b' est compris entre 2 et 8, en particulier entre 3 et 6.

Alternativement, l'arbre pourrait se présenter sous la forme d'un cylindre comprenant une portion de réception 10b' du pignon, et être usiné a posteriori de la deuxième étape E2'. En particulier, les portions de guidage 11b' pourraient être usinées a posteriori.

Bien entendu, l'invention ne se limite pas aux modes de réalisation décrits. Par exemple, la première partie 1a' du composant 1' pourrait présenter plusieurs portions disposées sur différents niveaux, à l'instar du composant 1. En alternative, la deuxième partie 1b' du composant 1' pourrait se présenter sous la forme d'un insert dont la hauteur totale est inférieure ou égale à la hauteur totale de la partie 1a', et pourrait ainsi s'inscrire au sein du volume défini par la première partie 1a'. En alternative encore, la partie 1a' pourrait constituer l'entier du composant 1'. Dans ces deux derniers cas de figure, la mise en oeuvre d'une couche inférieure C10' n'est pas obligatoire. Dans tous ces cas de figure, au moins une surface fonctionnelle de tout ou partie du composant 1' est parfaitement définie par une deuxième couche C30', notamment concernant son état de surface.

Avantageusement, elle peut permettre la fabrication de toute géométrie de composants horlogers, et donc de moules associés.

Finalement, l'invention repose sur un procédé de fabrication d'un moule multicouche en résine par photolithographie pour la fabrication d'un composant horloger, caractérisé en ce qu'il comprend les sous-étapes suivantes pour fabriquer au moins deux couches en résine du moule :
∘ Des sous-étapes de fabrication d'une première couche en résine, comprenant une première ouverture traversante ou débouchante orientée vers la direction de l'entrée de la cavité du moule, pour délimiter un premier volume de la cavité du moule ;
∘ Des sous-étapes de fabrication d'une deuxième couche en résine comprenant un film rigide, ladite deuxième couche comprenant une deuxième ouverture traversante délimitant un deuxième volume de la cavité du moule, la deuxième ouverture traversante de cette deuxième couche étant au moins partiellement superposée à la première ouverture traversante ou débouchante de la première couche et la deuxième couche en résine recouvrant partiellement cette même première ouverture traversante ou débouchante de la première couche en résine.

Un tel procédé permet d'obtenir un moule caractérisé en ce qu'il comprend :
∘ Une première couche en résine, comprenant une première ouverture traversante ou débouchante orientée vers la direction de l'entrée de la cavité du moule, délimitant un premier volume de la cavité du moule ;
∘ Une deuxième couche en résine comprenant un film rigide, ladite deuxième couche comprenant une deuxième ouverture traversante délimitant un deuxième volume de la cavité du moule, la deuxième ouverture traversante de cette deuxième couche étant au moins partiellement superposée à la première ouverture traversante ou débouchante de la première couche et la deuxième couche en résine recouvrant partiellement cette même première ouverture traversante ou débouchante de la première couche en résine.

Comme décrit précédemment, la deuxième couche comprend donc une portion qui vient au-dessus d'une partie d'une ouverture d'une première couche inférieure. Pour cette raison, elle comprend une résine comprenant un film rigide, lui permettant de conserver une forme continue et stable malgré cette configuration particulière, qui exerce des efforts sur les extrémités libres de la deuxième couche, suspendues au-dessus d'une première ouverture d'une première couche. Pour cela, la deuxième couche en résine peut comprendre l'application d'une résine comprenant un film sec, notamment un film SUEX ou ADEX de la maison DJ Microlaminates Inc. ou un film TMMF S2000 de la maison Tokyo Ohka Kogyo Co. Naturellement, tout autre film de résine atteignant la rigidité satisfaisante pourrait convenir. Par exemple, un tel film de résine présente avantageusement une rigidité caractérisée par un module d'élasticité compris entre 2 et 5 GPa (à 20°C). Ainsi, un tel film est avantageusement autoportant ou rigide, c'est-à-dire que son intégrité géométrique est assurée par sa seule rigidité. En complément, la deuxième couche présente avantageusement une épaisseur supérieure ou égale à 100 µm, avantageusement comprise entre 100 µm et 1 mm.

Les différentes autres résines des autres couches peuvent être identiques ou non à cette résine de la deuxième couche, comme cela a été discuté précédemment.

Naturellement, l'invention ne porte pas spécifiquement sur le dessin formé par la ou les ouvertures. Ces dernières peuvent être de forme cylindrique, ou de toute autre forme. De plus, il peut y avoir une ou plusieurs ouvertures par couches. Ainsi, le moule pourrait comprendre plusieurs cavités. La géométrie des ouvertures est imposée par le composant horloger à fabriquer. Enfin, le moule comprend au moins deux couches superposées, comme décrit précédemment, et pourrait en avoir trois ou plus. Ainsi, il pourrait comprendre plusieurs groupes de deux couches telles que décrites précédemment, avec plusieurs couches en résine comprenant un film rigide semblable à la deuxième couche décrite ci-dessus.

L'invention porte également sur un procédé de fabrication d'un composant horloger, caractérisé en ce qu'il comprend une première étape de fabrication d'un moule selon le procédé de fabrication décrit précédemment, et une deuxième étape de remplissage au moins partiel de la cavité du moule fabriqué à l'étape précédente, notamment de remplissage des premier et deuxième volumes de ladite cavité dudit moule, par un insert et/ou un matériau de remplissage, afin de fabriquer tout ou partie du composant horloger.

La deuxième étape de remplissage peut comprendre l'insertion d'un électrolyte par l'entrée de la cavité du moule et le remplissage d'au moins deux ouvertures de respectivement au moins deux couches du moule de sorte que la tout ou partie du composant horloger ainsi électroformée dans ladite cavité dudit moule se présente sous une forme monobloc, d'un seul tenant, sans superposition de couches distinctes.

Dans tous les cas, la deuxième ouverture du moule est au moins partiellement superposée à la première ouverture traversante ou débouchante de la première couche, pour former un volume continu correspondant au volume de la cavité du moule, et la deuxième couche en résine recouvre partiellement cette même première ouverture traversante ou débouchante de la première couche.

Par cette construction particulière du moule selon l'invention dans laquelle la première étape de fabrication d'un moule comprend la fabrication d'une couche du moule comprenant une ouverture traversante ou débouchante orientée vers la direction de l'entrée du moule, recouverte partiellement par une autre couche, les surfaces fonctionnelles inférieure et/ou supérieure, longitudinale, de tout ou partie du composant horloger obtenu par la deuxième étape de remplissage présentent une forme et notamment un état de surface parfaitement définis respectivement par une délimitation d'une surface de la cavité du moule. Le composant horloger présente ainsi avantageusement un très bon état de surface dès sa sortie de la cavité du moule.

D'autre part, le procédé de l'invention permet avantageusement de fabriquer un arbre horloger comprenant une denture. Avantageusement encore, cet arbre comprend une portion non métallique, enserrée par un pignon dont les surfaces fonctionnelles supérieure et inférieure sont parfaitement définies par des surfaces en résine de la cavité du moule, et dont les états de surface sont parfaitement maîtrisés par des états de surface des surfaces en résine de la cavité du moule.

Naturellement, le procédé précédemment décrit de fabrication d'un composant horloger ne se limite pas à la fabrication d'un arbre denté, et peut être utilisé pour la fabrication de composants horlogers tels que, à titre d'exemples illustratifs et non limitatifs, un arbre à came(s), une ancre pivotée (à savoir une ancre et son axe de pivotement), un balancier pivoté (à savoir un balancier et son axe de pivotement).

## Revendications

**1.** Procédé de fabrication par photolithographie d'un moule (10; 10') multicouche en résine comprenant une cavité (11 ; 11') dotée d'une entrée (110 ; 110') pour la fabrication d'un composant horloger, **caractérisé en ce qu'**il comprend les sous-étapes suivantes pour fabriquer au moins deux couches (C10, C20 ; C20', C30') en résine du moule (10 ; 10') :
∘ Des sous-étapes (E11, E12, E13 ; E105', E106', E107') de fabrication d'une première couche (C10 ; C20') en résine, comprenant une première ouverture (111 ; 111') traversante ou débouchante orientée vers la direction de l'entrée (110 ; 110') de la cavité (11 ; 11') du moule, pour délimiter un premier volume de la cavité (11 ; 11') du moule (10 ; 10') ;
∘ Des sous-étapes (E14, E15, E16; E108', E109', E110') de fabrication d'une deuxième couche (C20 ; C30') en résine comprenant un film rigide, ladite deuxième couche comprenant une deuxième ouverture (112 ; 112') traversante délimitant un deuxième volume de la cavité (11 ; 11') du moule (10 ; 10'), la deuxième ouverture (112 ; 112') traversante de cette deuxième couche étant au moins partiellement superposée à la première ouverture (111 ; 111') traversante ou débouchante de la première couche et la deuxième couche en résine recouvrant partiellement cette même première ouverture (111 ; 111') traversante ou débouchante de la première couche en résine.

**2.** Procédé de fabrication d'un moule selon la revendication précédente, **caractérisé en ce que** les sous-étapes (E14, E15, E16 ; E108', E109', E110') de fabrication d'une deuxième couche en résine comprennent l'application d'une résine comprenant un film sec, et/ou **en ce que** la deuxième couche en résine comprenant un film rigide présente un module d'élasticité compris entre 2 et 5 GPa et/ou une épaisseur supérieure ou égale à 100 µm et/ou est autoportante.

**3.** Procédé de fabrication d'un moule selon l'une des revendications précédentes, **caractérisé en ce qu'**il comprend :
∘ Des sous-étapes de fabrication de la première couche (C10 ; C20') en résine, comprenant:
- Déposer (E11 ; E105') une première résine photosensible ;
- Exposer (E12 ; E106') la première résine photosensible à travers un masque et développer (E13 ; E107') la résine pour former un moule (10 ; 10') comprenant la première ouverture (111 ; 111') traversante ou débouchante orientée vers la direction de l'entrée (110 ; 110') de la cavité (11 ;11') du moule, pour délimiter un premier volume de la cavité (11 ; 11') du moule ;
∘ Des sous-étapes de fabrication de la deuxième couche (C20 ; C30') en résine comprenant :
- Déposer (E14 ; E108') une deuxième résine photosensible comprenant un film sec, appliquée, notamment laminée, sur la première résine ;
- Exposer (E15 ; E109') la deuxième résine photosensible à travers un masque et développer (E16 ; E110') la résine pour former une cavité (11 ; 11') d'un moule (10 ; 10') comprenant la deuxième ouverture (112 ; 112') traversante.

**4.** Procédé de fabrication d'un moule selon l'une des revendications précédentes, **caractérisé en ce que** la deuxième ouverture (112 ; 112') traversante de la deuxième couche (C20 ; C30') en résine est centrée sur la première ouverture (111 ; 111') traversante ou débouchante de la première couche (C10 ; C20') en résine.

**5.** Procédé de fabrication d'un composant horloger (1 ; 1'), **caractérisé en ce qu'**il comprend une première étape (E1 ; E1') de fabrication d'un moule (10 ; 10') selon le procédé de fabrication selon l'une des revendications précédentes, et une deuxième étape (E2 ; E2') de remplissage au moins partiel de la cavité du moule fabriqué à l'étape précédente, notamment de remplissage des premier et deuxième volumes de ladite cavité dudit moule, afin de fabriquer tout ou partie du composant horloger.

**6.** Procédé de fabrication d'un composant horloger selon la revendication précédente, **caractérisé en ce que** la deuxième étape (E2 ; E2') de remplissage comprend un remplissage de tout ou partie de la cavité (11 ; 11') du moule (10 ; 10') par électrolyse, notamment par électroformage, comprenant la circulation d'un électrolyte par l'entrée (110 ; 110') de ladite cavité dudit moule.

**7.** Procédé de fabrication d'un composant horloger selon la revendication précédente, **caractérisé en ce que** la deuxième étape de remplissage comprend l'insertion d'un électrolyte par l'entrée de la cavité du moule et le remplissage d'au moins deux ouvertures de respectivement deux couches du moule de sorte que la tout ou partie du composant horloger ainsi électroformée dans ladite cavité dudit moule se présente sous une forme monobloc, d'un seul tenant, sans superposition de couches distinctes.

**8.** Procédé de fabrication d'un composant horloger selon l'une des revendications 5 à 7, **caractérisé en ce que** la première étape (E1 ; E1') de fabrication d'un moule (10 ; 10') comprend la fabrication d'une couche du moule comprenant une ouverture (111 ; 111') traversante ou débouchante orientée vers la direction de l'entrée (110 ; 110') de la cavité (11 ; 11') du moule, recouverte partiellement par une autre couche (C20 ; C30'), cette ouverture (111 ; 111') traversante ou débouchante orientée vers la direction de l'entrée (110 ; 110') de la cavité (11 ; 11') du moule de ladite couche formant un premier volume de la cavité du moule définissant tout ou partie du composant horloger à fabriquer, de sorte que les surfaces fonctionnelles inférieure et/ou supérieure de tout ou partie du composant horloger obtenu par la deuxième étape (E2 ; E2') de remplissage présentent une forme et notamment un état de surface parfaitement définis respectivement par une délimitation d'une surface de la cavité du moule.

**9.** Procédé de fabrication d'un composant horloger selon l'une des revendications 5 à 8, **caractérisé en ce qu'**il comprend une ouverture (114', 112') dans au moins une couche (C10' ; C30') du moule de format correspondant à un élément (1b') à insérer et **en ce qu'**il comprend une étape intermédiaire (E3') d'insertion d'un élément, notamment un arbre, dans ladite ouverture, de sorte à assurer le maintien dudit élément lors de la deuxième étape (E2') de remplissage, de sorte que la deuxième étape (E2') de remplissage au sein d'une partie de la cavité du moule permet de fabriquer une partie (1a') du composant horloger enserrant ledit élément (1b') inséré dans une partie de la cavité du moule, notamment **en ce qu'**il comprend une étape intermédiaire (E3') d'insertion d'un élément (1b'), notamment un arbre, dans la deuxième ouverture (112') traversante de la deuxième couche (C30') en résine et dans la première ouverture (111') traversante ou débouchante de la première couche (C20') en résine dudit moule.

**10.** Procédé de fabrication d'un composant horloger selon la revendication précédente, **caractérisé en ce que** la première étape (E1') de fabrication d'un moule (10') comprend la fabrication d'une couche inférieure (C10') comprenant une ouverture (114') inférieure, d'une deuxième couche (C30') supérieure comprenant une deuxième ouverture (112') supérieure centrée sur l'ouverture inférieure (114') de la couche inférieure (C10'), et d'une première couche (C20') intermédiaire entre la couche inférieure (C10') et la deuxième couche (C30') supérieure, cette première couche (C20') intermédiaire comprenant une première ouverture (111') traversante intermédiaire centrée sur les ouvertures (114', 112') de la couche inférieure et de la deuxième couche supérieure, cette première ouverture (111') traversante intermédiaire de la première couche (C20') intermédiaire comprenant une section dont la superficie est supérieure à celles des sections respectives des ouvertures (114', 112') de la couche inférieure et de la deuxième couche supérieure, cette première ouverture (111') traversante intermédiaire formant une partie de cavité (11') d'un moule (10') pour une partie (1a') du composant horloger (1'), et **caractérisé en ce que** la deuxième étape (E2') de remplissage au sein d'une partie de la cavité (11') du moule (10') permet de fabriquer un composant horloger (1') comprenant une partie (1a') dudit composant horloger (1') enserrant ledit élément (1b') inséré dans le moule.

**10.** Procédé de fabrication d'un composant horloger selon la revendication précédente, **caractérisé en ce qu'**il comprend une étape consistant à revêtir la couche inférieure (C10') du moule d'une couche métallique (21'), et **en ce que** la deuxième étape (E2') de remplissage au sein d'une partie de la cavité (11') du moule (10') comprend le remplissage par électroformage.

**11.** Procédé de fabrication d'un composant horloger selon l'une des revendications 9 ou 10, **caractérisé en ce qu'**il comprend une ouverture (112') dans la couche (C30') supérieure du moule (10') de format correspondant sensiblement à un élément (1b') à insérer pour assurer son guidage et/ou son maintien, ladite couche (C30') supérieure étant conformée pour :
- assurer le maintien élastique dudit élément lors de la deuxième étape (E2') de remplissage, l'ouverture (112') comprenant un motif (330') formant une structure élastique (331') ; et/ou
- permettre le passage du matériau de remplissage de la cavité du moule, notamment un électrolyte lorsque la deuxième étape (E2') comprend une étape d'électroformage, par un motif (330') formant une structure comprenant au moins un trou (332') dans la couche (C30') supérieure du moule (10') appartenant à l'entrée (110 ; 110') de la cavité (11 ; 11') du moule, et/ou par une structure définissant un jeu au niveau d'un élément inséré.

**12.** Procédé de fabrication d'un composant horloger selon l'une des revendications 9 à 11, **caractérisé en ce que** l'élément (1b') inséré est un arbre sensiblement cylindrique, de sorte que la deuxième étape (E2') de remplissage permet d'enserrer un pignon autour de l'arbre, dont les surfaces fonctionnelles supérieure et inférieure, notamment leur état de surface, sont parfaitement définies par des surfaces en résine du moule lors de cette deuxième étape (E2') de remplissage, pour former ainsi un composant horloger qui est un arbre horloger comprenant une denture.

**13.** Procédé de fabrication d'un composant horloger selon la revendication précédente, **caractérisé en ce que** l'élément (1b') inséré est un arbre sensiblement cylindrique en une céramique et **en ce que** le pignon est métallique, ledit arbre comprenant au moins une portée (102b') au niveau du pignon pour maximiser la tenue axiale dudit pignon sur l'arbre et/ou au moins une cannelure (101b') pour maximiser la tenue en couple dudit pignon sur l'arbre et/ou des différences de rugosités pour favoriser l'accroche dudit pignon sur l'arbre.

**14.** Moule (10 ; 10') multicouche en résine comprenant une cavité (11 ; 11') dotée d'une entrée (110 ; 110'), obtenu par photolithographie, pour la fabrication d'un composant horloger (1 ; 1'), **caractérisé en ce qu'**il comprend :
∘ Une première couche (C10 ; C20') en résine, comprenant une première ouverture (111 ; 111') traversante ou débouchante orientée vers la direction de l'entrée (110 ; 110') de la cavité (11 ; 11') du moule, délimitant un premier volume de la cavité du moule ;
∘ Une deuxième couche (C20 ; C30') en résine comprenant un film rigide, ladite deuxième couche comprenant une deuxième ouverture (112 ; 112') traversante délimitant un deuxième volume de la cavité du moule, la deuxième ouverture (112 ; 112') traversante de cette deuxième couche (C20 ; C30') étant au moins partiellement superposée à la première ouverture (111 ; 111') traversante ou débouchante de la première couche (C10 ; C20') et la deuxième couche (C20 ; C30') en résine recouvrant partiellement cette même première ouverture (111 ; 111') traversante ou débouchante de la première couche (C10 ; C20') en résine.
